# EUROPÄISCHE PATENTSCHRIFT

(11) **EP 1 520 290 B1**
(45) Veröffentlichungstag und Bekanntmachung des Hinweises auf die Patenterteilung: **25.08.2010**
(21) Anmeldenummer: 03740221.1
(22) Anmeldetag: 11.06.2003
(51) Int. Cl.: H01J 37/34

(54) **VORRICHTUNG ZUR BESCHICHTUNG VON SUBSTRATEN MITTELS PHYSIKALISCHER DAMPFABSCHEIDUNG ÜBER DEN HOHLKATHODENEFFEKT**
DEVICE FOR COATING SUBSTRATES BY PHYSICAL VAPOUR DEPOSITION, USING A HOLLOW CATHODE DISCHARGE METHOD
DISPOSITIF DE REVETEMENT DE SUBSTRATS PAR SEPARATION PHYSIQUE DE VAPEUR PAR L'EFFET DE CATHODE CREUSE

(30) Priorität: 17.06.2002 DE 10227048
(43) Veröffentlichungstag der Anmeldung: 06.04.2005
(73) Patentinhaber: Fraunhofer-Gesellschaft zur Förderung der angewandten Forschung e.V., 80686 München (DE)
(72) Erfinder: JUNG, Thomas, 38173 Hötzum (DE)
(74) Vertreter: Pfenning, Meinig & Partner GbR
(86) Internationale Anmeldenummer: PCT/EP2003/006113
(87) Internationale Veröffentlichungsnummer: WO 2003/107385

(56) Entgegenhaltungen:
- EP-A- 0 318 441
- US-A- 5 317 006
- ISHII K: "High-rate low kinetic energy gas-flow-sputtering system" JOURNAL OF VACUUM SCIENCE & TECHNOLOGY A (VACUUM, SURFACES, AND FILMS), MARCH-APRIL 1989, USA, Bd. 7, Nr. 2, Seiten 256-258, XP002268695 ISSN: 0734-2101 in der Anmeldung erwähnt

## Beschreibung

Die Erfindung betrifft eine Vorrichtung zur Beschichtung mittels physikalischer Dampfabscheidung von Substraten im Vakuum. Gasflußsputterquellen sind Beschichtungsquellen, die im Vakuum arbeiten und bei denen festes Material durch Kathodenzerstäubung in einer Hohlkathoden-Glimmentladung abgetragen wird und mittels eines Gasstromes aus der Hohlkathode heraus zum außerhalb der Hohlkathode befindlichen Substrat transportiert und dort niedergeschlagen wird.
Sie bestehen im Wesentlichen aus einer Hohlkathode mit einer rückwärtigen Öffnung zur Gas-Einströmung und einer vorderen Öffnung zur Abströmung des Gemisches aus Gas und abgestäubten Kathodenmaterial. Außerdem weisen sie eine Anode auf, wobei auch das Beschichtungsgefäß, in dem sich die Gasflußsputterquelle und das Substrat befinden, als Anode verwendet werden kann. Die Hohlkathodenentladung ist vom Typ einer Hohlkathoden-Glimmentladung, d. h. sie beruht auf dem sogenannten Hohlkathodeneffekt. An Hohlkathode und Anode wird eine elektrische Spannung von etwa 100 - 1000 V angelegt, meist eine Gleichspannung. Die Beschichtung erfolgt meist im Druckbereich von etwa 0.1 mbar bis 1 mbar, daher ist das Beschichtungsgefäß als Vakuumgefäß ausgebildet.

Zur Vermeidung einer Überhitzung der Hohlkathode durch den Ionenbeschuß und das Hohlkathodenplasma wird die Hohlkathode in der Regel gekühlt. Sie besteht daher meist aus dem sogenannten Target, das aus dem abzutragenden Material besteht und dem Hohlkathodenplasma zugewandt ist, sowie einer rückwärtigen Kühlvorrichtung für das Target, die mit diesem in engem Wärmekontakt steht.

Bekannt sind Gasflußsputterquellen mit unterschiedlichen Formen der Hohlkathode.

Ishii (J. Vac. Sci. Technol., Vol. A7, 1989, S. 256) beschreibt eine Gasflußsputterquelle, bei der die Hohlkathode die Form eines beidseitig offenen Zylinders aufweist und das Target aus einem Rohr besteht.

Die Verwendung einer zylindrischen Hohlkathode nach Ishii ist sehr aufwendig, da rohrförmige Targets meist schwer herstellbar und daher teuer sind. Außerdem ist ihre Kühlung sehr aufwendig, wenn gleichzeitig das Target leicht austauschbar sein soll und außerdem eine große Sicherheit gegen unbeabsichtigten Austritt des Kühlmediums (Wasser) gegeben sein soll.

In der DE 42 35 953 wird eine lineare Gasflußsputterquelle beschrieben, bei der zwei parallele ebene Targetplatten die Hohlkathode bilden.

Mit der linearen Gasflußsputterquelle gemäß DE 42 35 953 kann stets nur ein schmaler Substratstreifen beschichtet werden. Sollen jedoch größere Flächen beschichtet werden, so ist eine Substratbewegung erforderlich. Insbesondere bei der Beschichtung von runden, scheibenförmigen Substraten, die größer als der Quellenspalt sind, geht dabei viel Beschichtungsmaterial verloren, wenn die Randbereiche des Substrates beschichtet werden.

Außerdem geht an den Stirnseiten der Hohlkathode, die zum Gehäuse der Quelle gehören und nicht als Kathode arbeiten, ebenfalls viel Beschichtungsmaterial verloren, da sie ständig mitbeschichtet werden. Weiterhin gehen an diesen Stirnseiten auch viele Ladungsträger aus dem Plasma durch Rekombination verloren, was zu einer Abschwächung des Plasmas und damit zu einer Verminderung der Beschichtungsgeschwindigkeit führt. Aus dem gleichen Grunde werden auch die Targets im Bereich der Stirnseiten durch die dort geringere Plasmadichte vermindert abgetragen. Dieser Materialrückstand kann aber meist nicht mehr verwendet werden und vermindert so die Materialausbeute des Beschichtungsmaterials.

Die DE 42 10 125 C2 beschreibt eine Gasflußsputterquelle, in der die Hohlkathode die Form eines zum Substrat hin offenen Kegelstumpf-Mantels aufweist und das Target aus vier trapezförmigen ebenen Platten besteht.

Mit der in DE 42 10 125 C2 beschriebenen Gasflußsputterquelle können zwar scheibenförmige Substrate ohne Substratbewegung und ohne großen Materialverlust beschichtet werden, jedoch ist durch die stark geneigte Form der einzelnen Targetplatten infolge der hohen Ladungsträgerverluste nach außen der Hohlkathodeneffekt stark abgeschwächt und damit die Beschichtungsgeschwindigkeit gering. Außerdem erlaubt die offene Form ein leichtes Eindringen von Reaktivgas, wie es beim reaktiven Gasflußsputtern zur Herstellung von Verbindungsschichten, z. B. von Oxidschichten, benötigt wird, in die Kathode, was zu sehr unerwünschten Oberflächenreaktionen an den Targets führen kann, die ihrerseits zur Instabilität der Entladung und zu starker Verminderung der Beschichtungsgeschwindigkeit führen.

Allen drei Gasflußsputterquellen ist als weiterer, wesentlicher Nachteil gemeinsam, daß sie nur mit relativ geringer Leistung betrieben werden können, da die Hohlkathodenentladung am Targetrand stets schwächer ist, die Targets dort daher kühler bleiben als in der Mitte und dadurch bei hoher Leistung aufgrund innerer thermomechanischer Spannungen reißen und aufgrund der Risse anschließend durch das Hohlkathodenplasma zerstört werden. Da die Materialmenge, die aus einer Gasflußsputterquelle auf ein Substrat pro Zeiteinheit abgeschieden wird, umso größer ist, je höher die Plasmaleistung ist, können mit diesen Quellen keine sehr hohen Beschichtungsgeschwindigkeiten erreicht werden.

Die US5317006 offenbart ein zylindrische Magnetron-Sputter-System mit einer Hohlkathode. Die Hohlkathode beinhaltet dabei einen Metallzylinder und Materialstreifen, welche auf der Innenseite des Metallzylinders angebracht sein können und/oder Material welches auf die Innenseite des Metallzylinders aufgesprüht ist. Die Materialstreifen bilden das Target und sind u.a. in Form eines Prismas ausgebindet. Dabei ist festzustellen, dass Hohlkathoden-Gasfluss-Sputterquellen, wie sie in der vorliegende Erfindung eingesetzt werden, und Hohlkathoden-Magnetrons, wie sie in der US5317006 eingesetzt werden, deutliche Unterschiede hinsichtlich Plasmaerzeugung, Materialtransport und Arbeitsdruck aufweisen.

Der Erfindung liegt die Aufgabe zugrunde, eine Gasflußsputterquelle anzugeben, die die genannten Nachteile der bekannten Gasflußsputterquellen vermeidet und insbesondere zur Einzel-Beschichtung von Substraten mit sehr hoher Beschichtungsgeschwindigkeit geeignet ist.

Diese Aufgabe wird durch die gattungsgemäße Vorrichtung mit den kennzeichnenden Merkmalen des Anspruchs 1 gelöst. Die weiteren abhängigen Ansprüche zeigen vorteilhafte Weiterbildungen auf. In den Ansprüchen 17 bis 21 werden die Verwendungen der Vorrichtung aufgezeigt.

Erfindungsgemäß wird eine Vorrichtung zur Beschichtung von Substraten mittels physikalischer Dampfabscheidung über den Hohlkathodeneffekt bereitgestellt. Diese ist aus einem Vakuumgehäuse mit einer Hohlkathode, einer Anode sowie jeweils mindestens einer Öffnung für den Gaseintritt und den Gasaustritt aufgebaut, die an der Hohlkathode angeordnet sind. Die Hohlkathode ist dabei aus mindestens vier die Seitenflächen eines Prismas bildenden Targets aufgebaut. Das Target besteht dabei aus dem abzutragenden Material und ist dem Hohlkathodenplasma zugewandt. Die benachbarten Targets sind erfindungsgemäß durch einen Spalt voneinander getrennt.

Besonderer Vorteil der erfindungsgemäßen Vorrichtung ist es, daß auf diese Weise leicht herstellbare Targetplatten verwendet werden können. Aufgrund der geringen Größe der Targetplatten kommt es auch bei starker Erwärmung aufgrund des Ionenbeschusses und des Hohlkathodenplasmas nicht zur mechanischen Zerstörung der Targets. Daher können die Targets mit sehr hoher Plasmaleistung belastet werden, was eine hohe Beschichtungsgeschwindigkeit ermöglicht. Ebenso ermöglichst die polygonale Form eine gute Anpassung an runde oder isotrope Substrate. Dadurch können runde Substrate der häufig vorkommenden Größe im Bereich zwischen 5 und 20 cm ohne oder mit geringer Substratbewegung beschichtet werden, wodurch der Materialverlust hinsichtlich des Beschichtungsmaterials minimiert bzw. gänzlich vermieden werden kann. Gleichzeitig gehen auch wenige Ladungsträger verloren, wodurch eine hohe Plasmaleistung und folglich eine hohe Beschichtungsgeschwindigkeit realisiert wird.

Vorzugsweise sind die Targets in Form eines regulären polygonalen Prismas angeordnet, so daß die Grundfläche der Hohlkathode die Form eines regelmäßigen Vierecks, Fünfecks, usw. aufweist.

Ebenso ist es aber auch möglich, daß die Targets in Form eines nicht regulären polygonalen Prismas angeordnet sind. Hiermit kann eine gezielte Anpassung der Hohlkathodenform an die Substratform erfolgen. Ebenso ist es möglich, in dieser Variante unterschiedlich große Einzeltargets zu verwenden.

Vorzugsweise ist die Vorrichtung derart ausgestaltet, daß die Anzahl der Seitenflächen des Prismas zwischen sechs und zwölf beträgt. Durch die Verwendung einer entsprechenden Anzahl von Einzeltargets können so nahezu beliebige Substratformen in der Vorrichtung beschichtet werden.

In einer vorteilhaften Weiterbildung der Vorrichtung ist mindestens eine Seitenfläche aus mehreren Targets gebildet. Vorzugsweise ist es dabei möglich, daß für mehrkomponentige Beschichtungen die Targets mindestens einer Seitenfläche aus unterschiedlichen Materialien bestehen. Dies bringt den wichtigen Vorteil mit sich, daß bei der Herstellung mehrkomponentiger Beschichtungen auf die teuere Herstellung von Legierungstargets verzichtet werden kann. Durch die Kombination verschiedener Einzeltargets aus unterschiedlichen Materialien kann die Zusammensetzung der Schicht durch den Flächenanteil der Einzeltargets der jeweiligen Komponenten exakt eingestellt werden.

Bevorzugt sind in der Vorrichtung an gegenüberliegenden Stirnflächen des Prismas die mindestens eine Öffnung für den Gaseintritt und den Gasaustritt angeordnet. Dabei kann die Vorrichtung auch mindestens eine Öffnung für den Gaseintritt eines Reaktivgases, insbesondere Sauerstoff, Stickstoff oder Kohlenwasserstoff, aufweisen.

Apparativ ist die Vorrichtung vorzugsweise derart ausgestaltet, daß der innere Durchmesser des Prismas, also der Hohlkathoden-Innenraum zwischen 2 und 20 cm, besonders bevorzugt zwischen 6 und 15 cm beträgt. Das Verhältnis zwischen der Höhe des Prismas und dessen Durchmesser liegt dabei bevorzugt zwischen 1,5 : 1 und 6 : 1.

Die Targets bestehen dabei vorzugsweise aus ebenen Platten, da diese leicht herzustellen und somit kostengünstig sind.

Die zwischen den benachbarten Targets angeordneten Spalten weisen eine Breite zwischen 0,3 und 3 mm auf. Dabei sind die Targets vorzugsweise so ausgestaltet, daß die Breite der Spalte zwischen den Targets während des Abtrages konstant bleibt.

Die Höhe und die Breite der Targets ist sowohl im Hinblick auf die einzelnen Targets als auch auf die Höhe und die Breite unabhängig von einander und beträgt bevorzugt zwischen 1 und 8 cm, besonders bevorzugt zwischen 3 und 5 cm. Die Dicke der Targets liegt bevorzugt zwischen 0,1 und 5 cm, besonders bevorzugt zwischen 0,5 und 2,5 cm.

Um Überhitzungen der Hohlkathode zu vermeiden, sind die Targets vorzugsweise mit mindestens einem Kühlkörper verbunden. Die Verbindung der Targets mit dem Kühlkörper erfolgt dabei vorzugsweise über eine zentrale Schraube, so daß das Target mit seiner Rückseite den Kühlkörper zwar ganzflächig berührt, jedoch nur punktuell mittig befestigt ist.

Verwendung findet die erfindungsgemäße Vorrichtung bei der Herstellung von Metallschichten. Ebenso eignet sich die Vorrichtung für die Herstellung von Verbindungsschichten, z. B. Oxid-, Nitrid- und Carbidschichten. So beispielhaft seien hier Beschichtungen aus Aluminiumoxid, Zirkoniumoxid, Titanoxid, Siliziumoxid, Magnesiumoxid, Titannitrid, Chromnitrid und Titancarbid genannt. In gleicher Weise können mit der erfindungsgemäßen Vorrichtung auch Kohlenstoffschichten hergestellt werden.

Die erfindungsgemäße Vorrichtung läßt sich für beliebige Substrate einsetzen, wobei besonders die Beschichtung von scheibenförmigen Substraten, beispielsweise Datenträgern, Brillengläsern, Smart-Cards, Brennstoffzellenelementen und Gasturbinenschaufeln in einfacher Weise ermöglicht wird. Die erfindungsgemäße Vorrichtung kann dabei auch zur Einzelbeschichtung von Bauteilen in einer Kurztaktanlage eingesetzt werden.

Anhand der folgenden Figuren soll der anmeldungsgemäße Gegenstand näher erläutert werden, ohne diesen auf diese in den Ausführungsbeispielen dargestellten Varianten einzuschränken.
- Fig. 1: zeigt eine schematische Darstellung des Querschnitts einer erfindungsgemäßen Gas- flußsputterquelle.
- Fig. 2: zeigt in einer Schnittdarstellung die aus mehreren Einzeltargets bestehende Seiten- fläche des Prismas.
- Fig. 3: zeigt in einer schematischen Darstellung die tetragonale Grundfläche einer erfin- dungsgemäßen Gasflußsputterquelle.
- Fig. 4: zeigt schematisch in einer Schnittdarstel- lung eine aus mehreren Einzeltargets aus unterschiedlichen Materialien bestehende Seitenfläche des Prismas.
- Fig. 5: zeigt in einer schematischen Darstellung eine nicht reguläre oktaetrische Grundflä- che einer erfindungsgemäßen Gasflußsputter- quelle.

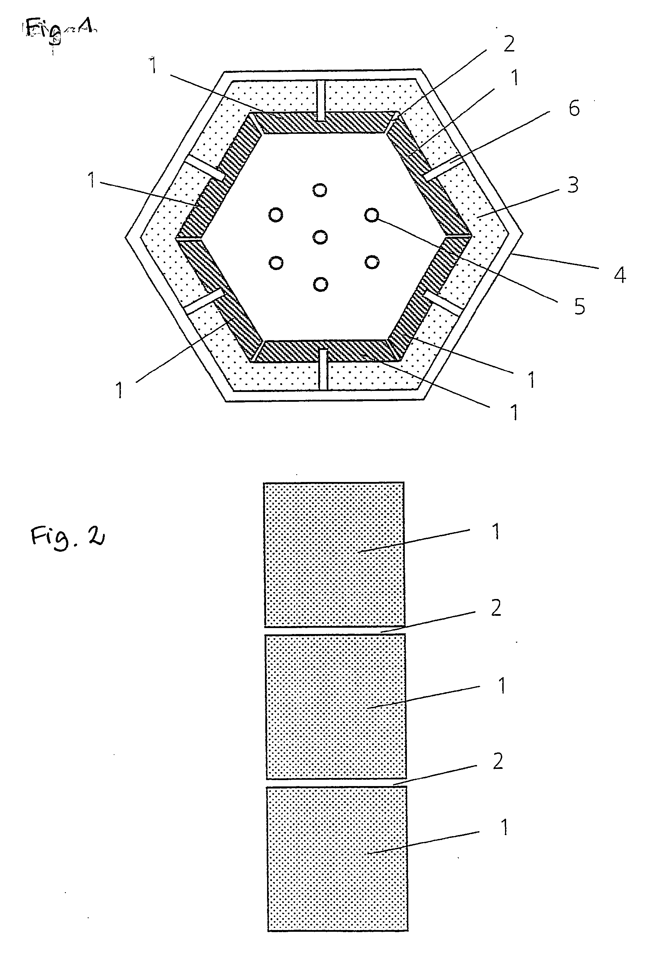

Fig. 1 zeigt eine Gasflußsputterquelle aus einem Gehäuse 4 mit einem Target in der Form eines regulären hexagonalen Prismas im Querschnitt aus der Perspektive des Substrates. Die Teiltargets 1 sind von hinten mit je einer zentralen Schraube 6 befestigt und durch Spalte 2 voneinander getrennt. Kühlkörper 3 und Abschirmung sind in ihrer Form der Hohlkathode angepaßt. Die Transportgaseinspeisung erfolgt durch eine Vielzahl von Öffnungen 5 die sich in einer Ebene an jenem Ende der Hohlkathode, also des Prismas, befinden, das nicht zum Substrat gerichtet ist.

Fig. 2 ist eine der sechs Innenflächen der Hohlkathode dargestellt. Sie besteht aus drei gleichgroßen Teiltargets 1 aus dem gleichen Material, die durch Spalte 2 voneinander getrennt sind. Die übrigen fünf Innenflächen sind nicht dargestellt und sehen gleichartig aus.

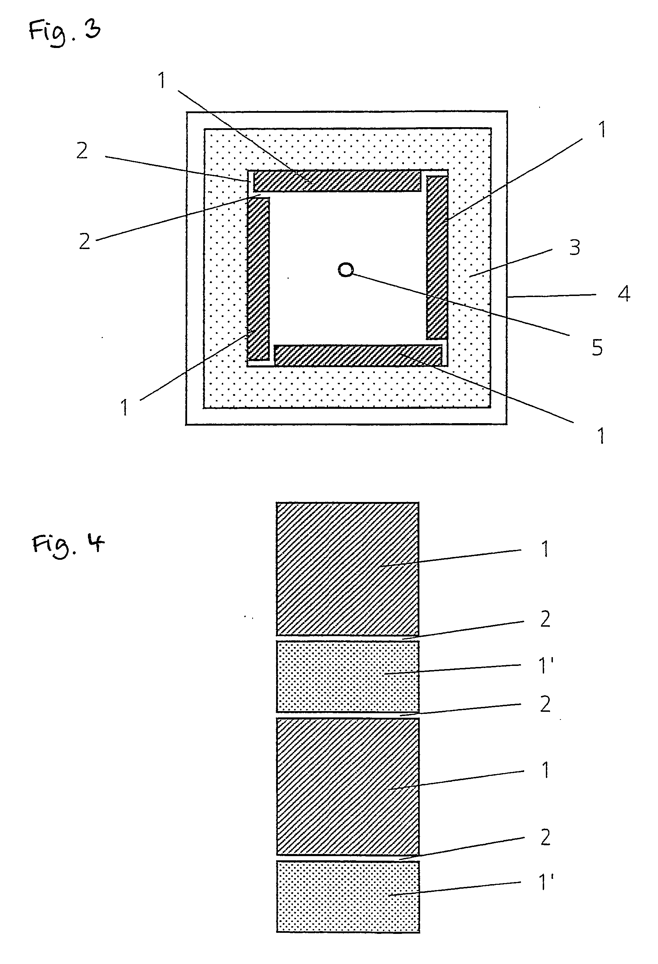

Fig. 3 zeigt eine Gasflußsputterquelle aus einem Gehäuse 4 mit einem Target in der Form eines regulären tetragonalen Prismas im Querschnitt aus der Perspektive des Substrates. Die Teiltargets 1 sind durch Spalte 2 voneinander getrennt. Kühlkörper 3 und Abschirmung sind in ihrer Form der Hohlkathode angepaßt. Die Transportgaseinspeisung erfolgt durch eine zentrale Öffnung 5, die sich an jenem Ende der Hohlkathode, also des Prismas, befindet, das nicht zum Substrat gerichtet ist.

In Fig. 4 ist eine der vier Innenflächen der Hohlkathode dargestellt. Sie besteht aus vier ungleich großen Teiltargets 1 aus zwei unterschiedlichen Materialien, die durch Spalte 2 voneinander getrennt sind. Die übrigen drei Innenflächen sind nicht dargestellt und sehen gleichartig aus.

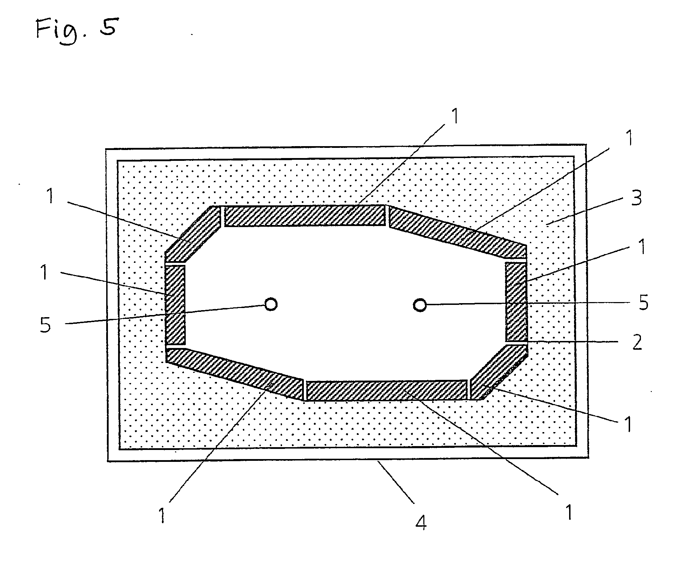

Fig. 5 zeigt eine Gasflußsputterquelle aus einem Gehäuse 4 mit einem Target in der Form eines nichtregulären oktagonalen Prismas im Querschnitt aus der Perspektive des Substrates. Die Teiltargets 1 sind durch Spalte 2 voneinander getrennt. Kühlkörper 3 und Abschirmung haben die Form eines Rechteckprismas. Die Transportgaseinspeisung erfolgt durch zwei zentrale Öffnungen 5, die sich an jenem Ende der Hohlkathode, also des Prismas, befindet, das nicht zum Substrat gerichtet ist.

Die Innenflächen der Hohlkathode sind nicht dargestellt. Sie bestehen aus unterschiedlich großen Teiltargets aus einem einheitlichen Material, die durch Spalten getrennt sind.

## Patentansprüche

1. Vorrichtung zur Beschichtung von Substraten mittels physikalischer Dampfabscheidung über den Hohlkathodeneffekt
enthaltend ein Vakuumgehäuse (4) mit einer Hohlkathode, einer Anode sowie jeweils mindestens einer Öffnung (5) für den Gaseintritt und den Gasaustritt, wobei
die Hohlkathode aus mindestens vier Seitenflächen eines Prismas bildenden Targets (1) aufgebaut ist, wobei die benachbarten Targets (1) durch einen Spalt (2) voneinander getrennt sind, **dadurch gekennzeichnet, dass** der Spalt eine Breite zwischen 0,3 und 3 mm besitzt.

2. Vorrichtung nach Anspruch 1,
**dadurch gekennzeichnet, dass** die Targets (1) in Form eines regulären polygonalen Prismas angeordnet sind.

3. Vorrichtung nach Anspruch 1,
**dadurch gekennzeichnet, dass** die Targets (1) in Form eines nichtregulären polygonalen Prismas angeordnet sind.

4. Vorrichtung nach mindestens einem der Ansprüche 1 bis 3,
**dadurch gekennzeichnet, dass** die Anzahl der Seitenflächen des Prismas zwischen 6 und 12 beträgt.

5. Vorrichtung nach mindestens einem der Ansprüche 1 bis 4,
**dadurch gekennzeichnet, dass** mindestens eine Seitenfläche aus mehreren Targets (1) gebildet ist.

6. Vorrichtung nach Anspruch 5,
**dadurch gekennzeichnet, dass** für mehrkomponentige Beschichtungen die Targets (1) mindestens einer Seitenfläche aus unterschiedlichen Materialien bestehen.

7. Vorrichtung nach mindestens einem der Ansprüche 1 bis 6,
**dadurch gekennzeichnet, dass** an gegenüber liegenden Stirnflächen des Prismas die mindestens eine Öffnung (5) für den Gaseintritt und den Gasaustritt angeordnet sind.

8. Vorrichtung nach mindestens einem der Ansprüche 1 bis 7,
**dadurch gekennzeichnet, dass** die Vorrichtung mindestens eine Öffnung (5) für den Gaseintritt eines Reaktivgases, insbesondere Sauerstoff, Stickstoff oder Kohlenwasserstoff, aufweist.

9. Vorrichtung nach mindestens einem der Ansprüche 1 bis 8,
**dadurch gekennzeichnet, dass** der innere Durchmesser des Prismas zwischen 2 und 20 cm, bevorzugt zwischen 6 und 15 cm beträgt.

10. Vorrichtung nach mindestens einem der Ansprüche 1 bis 9,
**dadurch gekennzeichnet, dass** das Verhältnis zwischen der Höhe des Prismas und dessen Durchmesser zwischen 1,5:1 und 6:1 liegt.

11. Vorrichtung nach mindestens einem der Ansprüche 1 bis 10,
**dadurch gekennzeichnet, dass** die Targets (1) aus ebenen Platten bestehen.

12. Vorrichtung nach mindestens einem der Ansprüche 1 bis 11,
**dadurch gekennzeichnet, dass** die Targets (1) so ausgeformt sind, dass die Breite der Spalte (2) zwischen den Targets (1) während des Abtrages konstant bleibt.

13. Vorrichtung nach mindestens einem der Ansprüche 1 bis 12,
**dadurch gekennzeichnet, dass** die Höhe und Breite der Targets (1) unabhängig voneinander zwischen 1 und 8 cm, bevorzugt zwischen 3 und 5 cm beträgt.

14. Vorrichtung nach mindestens einem der Ansprüche 1 bis 13,
**dadurch gekennzeichnet, dass** die Dicke der Targets (1) zwischen 0,1 und 5 cm, bevorzugt zwischen 0,5 und 2,5 cm beträgt.

15. Vorrichtung nach mindestens einem der Ansprüche 1 bis 14,
**dadurch gekennzeichnet, dass** die Targets (1) mit mindestens einem Kühlkörper (3) verbunden sind.

16. Vorrichtung nach Anspruch 15,
**dadurch gekennzeichnet, dass** die Targets (1) über eine zentrale Schraube (6) mit dem Kühlkörper (3) verbunden sind.

17. Verwendung der Vorrichtung nach mindestens einem der Ansprüche 1 bis 16 zur Herstellung von Metallschichten.

18. Verwendung der Vorrichtung nach mindestens einem der Ansprüche 1 bis 16 zur Herstellung von Oxid-, Nitrid- und Carbidschichten, insbesondere aus Aluminiumoxid, Zirkoniumoxid, Titanoxid, Siliziumoxid, Magnesiumoxid, Titannitrid, Chromnitrid und Titancarbid.

19. Verwendung der Vorrichtung nach mindestens einem der Ansprüche 1 bis 16 zur Herstellung von Kohlenstoffschichten.

20. Verwendung der Vorrichtung nach mindestens einem der Ansprüche 1 bis 16 zur Herstellung von Beschichtungen von scheibenförmigen Substraten, insbesondere Datenträgern, Brillengläsern, Smart cards, Brennstoffzellenelementen und Gasturbinenschaufeln.

21. Verwendung der Vorrichtung nach mindestens einem der Ansprüche 1 bis 16 zur Einzelbeschichtung in einer Kurztaktanlage.

## Claims

1. A device for coating substrates by means of physical vapour deposition by means of the hollow-cathode effect
containing a vacuum housing (4) with a hollow cathode, an anode and in each case at least one opening (5) for gas to enter and to emerge, wherein
the hollow cathode is constructed from at least four targets (1) forming lateral faces of a prism, the adjacent targets (1) being separated from one another by a gap (2), **characterised in that** the gap has a width of between 0.3 and 3 mm.

2. A device according to Claim 1, **characterised in that** the targets (1) are arranged in the form of a regular polygonal prism.

3. A device according to Claim 1, **characterised in that** the targets (1) are arranged in the form of a non-regular polygonal prism.

4. A device according to at least one of Claims 1 to 3, **characterised in that** the number of lateral faces of the prism is between 6 and 12.

5. A device according to at least one of Claims 1 to 4, **characterised in that** at least one lateral face is formed of a plurality of targets (1).

6. A device according to Claim 5, **characterised in that** for multi-component coatings the targets (1) of at least one lateral face consist of different materials.

7. A device according to at least one of Claims 1 to 6, **characterised in that** the at least one opening (5) for gas to enter and to emerge is/are arranged on opposing end faces of the prism.

8. A device according to at least one of Claims 1 to 7, **characterised in that** the device has at least one opening (5) for a reactive gas, in particular oxygen, nitrogen or hydrocarbon, to enter.

9. A device according to at least one of Claims 1 to 8, **characterised in that** the inner diameter of the prism is between 2 and 20 cm, preferably between 6 and 15 cm.

10. A device according to at least one of Claims 1 to 9, **characterised in that** the ratio of the height of the prism to its diameter is between 1.5:1 and 6:1.

11. A device according to at least one of Claims 1 to 10, **characterised in that** the targets (1) consist of flat plates.

12. A device according to at least one of Claims 1 to 11, **characterised in that** the targets (1) are formed such that the width of the gaps (2) between the targets remains constant during removal.

13. A device according to at least one of Claims 1 to 12, **characterised in that** the height and width of the targets (1) independently of each other is between 1 and 8 cm, preferably between 3 and 5 cm.

14. A device according to at least one of Claims 1 to 13, **characterised in that** the thickness of the targets (1) is between 0.1 and 5 cm, preferably between 0.5 and 2.5 cm.

15. A device according to at least one of Claims 1 to 14, **characterised in that** the targets (1) are connected to at least one cooling body (3).

16. A device according to Claim 15, **characterised in that** the targets (1) are connected to the cooling body (3) via a central screw (6).

17. Use of the device according to at least one of Claims 1 to 16 for the production of metal layers.

18. Use of the device according to at least one of Claims 1 to 16 for the production of oxide, nitride and carbide layers, in particular of aluminium oxide, zirconium oxide, titanium oxide, silicon oxide, magnesium oxide, titanium nitride, chromium nitride and titanium carbide.

19. Use of the device according to at least one of Claims 1 to 16 for the production of carbon layers.

20. Use of the device according to at least one of Claims 1 to 16 for the production of coatings of plate-shaped substrates, in particular data carriers, spectacle lenses, smart cards, fuel cell elements and gas turbine blades.

21. Use of the device according to at least one of Claims 1 to 16 for individual coating in a short-cycle plant.

## Revendications

1. Dispositif pour le revêtement de substrats au moyen d'un dépôt physique en phase vapeur utilisant l'effet de la cathode creuse,
contenant un boîtier sous vide (4) avec une cathode creuse, une anode, ainsi que respectivement au moins une ouverture (5) pour l'entrée de gaz et la sortie de gaz, dans lequel la cathode creuse est constituée d'au moins quatre surfaces latérales d'une cible (1) formant des prismes, les cibles (1) adjacentes étant séparées l'une de l'autre par une fente (2), **caractérisé en ce que** la fente possède une largeur comprise entre 0,3 et 3 mm.

2. Dispositif selon la revendication 1,
**caractérisé en ce que** les cibles (1) sont agencées sous la forme d'un prisme polygonal régulier.

3. Dispositif selon la revendication 1,
**caractérisé en ce que** les cibles (1) sont agencées sous la forme d'un prisme polygonal non régulier.

4. Dispositif selon au moins l'une quelconque des revendications 1 à 3,
**caractérisé en ce que** le nombre de surfaces latérales du prisme est compris entre 6 et 12.

5. Dispositif selon au moins l'une quelconque des revendications 1 à 4,
**caractérisé en ce qu'**au moins une surface latérale est formée de plusieurs cibles (1).

6. Dispositif selon la revendication 5,
**caractérisé en ce que**, pour des revêtements à plusieurs composants, les cibles (1) d'au moins une surface latérale sont constituées de matériaux différents.

7. Dispositif selon au moins l'une quelconque des revendications 1 à 6,
**caractérisé en ce que** la au moins une ouverture (5) pour l'entrée et la sortie de gaz est agencée sur des surfaces frontales opposées l'une de l'autre du prisme.

8. Dispositif selon au moins l'une quelconque des revendications 1 à 7,
**caractérisé en ce que** le dispositif présente au moins une ouverture (5) pour l'entrée d'un gaz réactif, en particulier l'oxygène, l'azote ou un hydrocarbure.

9. Dispositif selon au moins l'une quelconque des revendications 1 à 8,
**caractérisé en ce que** le diamètre interne du prisme est compris entre 2 et 20 cm, de préférence, entre 6 et 15 cm.

10. Dispositif selon au moins l'une quelconque des revendications 1 à 9,
**caractérisé en ce que** le rapport entre la hauteur du prisme et son diamètre se situe entre 1, 5 :1 et 6:1.

11. Dispositif selon au moins l'une quelconque des revendications 1 à 10,
**caractérisé en ce que** les cibles (1) sont constituées de plaques planes.

12. Dispositif selon au moins l'une quelconque des revendications 1 à 11,
**caractérisé en ce que** les cibles (1) sont formées de sorte que la largeur des fentes (2) entre les cibles (1) reste constante lors de l'enlèvement.

13. Dispositif selon au moins l'une quelconque des revendications 1 à 12,
**caractérisé en ce que** la hauteur et la largeur des cibles (1) sont, indépendamment l'une de l'autre, comprises entre 1 et 8 cm, de préférence, entre 3 et 5 cm.

14. Dispositif selon au moins l'une quelconque des revendications 1 à 13,
**caractérisé en ce que** l'épaisseur des cibles (1) est comprise entre 0,1 et 5 cm, de préférence, entre 0,5 et 2,5 cm.

15. Dispositif selon au moins l'une quelconque des revendications 1 à 14,
**caractérisé en ce que** les cibles (1) sont reliées à au moins un dissipateur thermique (3).

16. Dispositif selon la revendication 15,
**caractérisé en ce que** les cibles (1) sont reliées au dissipateur thermique (3) par le biais d'une vis centrale (6).

17. Utilisation du dispositif selon au moins l'une quelconque des revendications 1 à 16, dans le but de fabriquer des couches de métal.

18. Utilisation du dispositif selon au moins l'une quelconque des revendications 1 à 16, dans le but de fabriquer des couches d'oxyde, de nitrure et de carbure, en particulier, d'oxyde d'aluminium, d'oxyde de zirconium, d'oxyde de titane, d'oxyde de silicium, d'oxyde de magnésium, de nitrure de titane, de nitrure de chrome et de carbure de titane.

19. Utilisation du dispositif selon au moins l'une quelconque des revendications 1 à 16, dans le but de fabriquer des couches de carbone.

20. Utilisation du dispositif selon au moins l'une quelconque des revendications 1 à 16, dans le but de fabriquer des revêtements de substrats en forme de disque, en particulier, des supports de données, des verres de lunettes, des cartes à puce, des éléments de piles à combustible et des aubes de turbines à gaz.

21. Utilisation du dispositif selon au moins l'une quelconque des revendications 1 à 16, pour effectuer un revêtement individuel dans une installation à cycle court.
